# EUROPÄISCHE PATENTSCHRIFT

(11) **EP 1 501 127 B1**
(45) Veröffentlichungstag und Bekanntmachung des Hinweises auf die Patenterteilung: **24.06.2009**
(21) Anmeldenummer: 04014433.9
(22) Anmeldetag: 19.06.2004
(51) Int. Cl.: H01L 25/07, H01L 23/373, H01L 23/492, H01L 21/48

(54) **Verfahren zur Herstellung eines Leistungshalbleitermoduls mit biegesteifer Grundplatte**
Method of manufacturing a power semiconductor module with a base plate having high bending stiffness
Méthode de fabrication d'un module semiconducteur de puissance avec une plaque de support résistante à la flexion

(30) Priorität: 23.07.2003 DE 10333329
(43) Veröffentlichungstag der Anmeldung: 26.01.2005
(73) Patentinhaber: SEMIKRON Elektronik GmbH & Co. KG, 90431 Nürnberg (DE)
(72) Erfinder: Manz, Yvonne, 91085 Weisendorf (DE); Steger, Jürgen, 91355 Hilpoltstein (DE); Jäger, Harald, 90542 Eckental (DE); Rüger, Herbert, 95236 Stammbach (DE); Matthes, Jürgen, 95131 Schwarzbach (DE)

(56) Entgegenhaltungen:
- EP-A- 0 400 177
- EP-A2- 0 144 866
- WO-A-01/08219
- WO-A-03/046981
- DE-C1- 10 064 979
- JP-A- 60 216 572
- US-A1- 2002 003 819

## Beschreibung

Die Erfindung beschreibt ein Verfahren zur Herstellung eines Leistungshalbleitermoduls, welches aus einem Gehäuse mit Grundplatte und mindestens einem darin angeordneten elektrisch isolierenden Substrat besteht. Dieses Substrat besteht seinerseits aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Vorteilhafterweise weist das Substrat auf seiner Unterseite eine flächige metallische Schicht, vergleichbar den Verbindungsbahnen, auf. Weiterhin weisen derartige Leistungshalbleitermodule Anschlusselemente für Last- und Hilfskontakte auf.

Leistungshalbleitermodule, die Ausgangspunkt dieser Erfindung sind, sind beispielhaft bekannt aus DE 103 16 355. Derartige Leistungshalbleitermodule weisen eine Grundplatte zur thermischen Kopplung an einen Kühlkörper auf. Hierfür ist es von besonderer Bedeutung, dass die Grundplatte nach der Befestigung des Leistungshalbeitermoduls möglichst vollständig in Kontakt mit dem Kühlkörper ist um einen effizienten Wärmeübergang zu gewährleisten. Da bei modernen Leistungshalbleitermodulen besonderer Wert auf eine kompakte Bauform gelegt wird und deswegen der Flächenanteil des Substrates mit den darauf angeordneten Leistungshalbleiterbauelementen besonders hoch ist, weisen diese Leistungshalbleitermodule ausschließlich in den Eckbereichen Verbindungseinrichtungen zur Verbindung mit dem Kühlkörper auf. Besonders Leistungshalbleitermodule mit hohen Leistungen weisen vorteilhafterweise eine Bauform auf, bei der die Längsausdehnung wesentlich größer ist als die Querausdehnung. Es ist bevorzugt, dass das Substrat auf der der Grundplatte zugewandten Seite eine weitere Metallisierung aufweist. Mittels dieser Metallisierung sind die Substrate stoffschlüssig mit der Grundplatte verbunden. Nach dem Stand der Technik wird diese Verbindung mittels Löten hergestellt.

Aus der WO03/046981 ist ein Halbleitermodul mit einem keramischen Substrat, einem Kühlkörper und einer Grundplatte aus Aluminium bekannt, welche grabenförmige Aussparungen aufweist, die den durch die unterschiedlichen Wärmeausdehnungskoeffizienten bedingten Stress verringern.

Aus der EP 0 144 8066 A2 ist ein Leistungshalbleitermodul mit einer aus Kupfer oder einer Kupferlegierung bestehenden Grundplatte bekannt.

Bei Leistungshalbleitermodulen mit vergleichsweise großer Längsausdehnung kann eine Lötverbindung der Substrate und der Grundplatte zu einer konkaven Durchbiegung der Grundplatte führen. Unter konkaver Durchbiegung soll hier eine Durchbiegung verstanden werden, bei der die Durchbiegung des Mittelbereichs der Grundplatte in Richtung des Leistungshalbleitermoduls erfolgt, unter konvexer Durchbiegung wird eine Durchbiegung in Richtung des Kühlkörpers verstanden. Vorteilhaft für einen effizienten Wärmeübergang zwischen dem Leistungshalbleitermodul und dem Kühlkörper ist eine konvexe Durchbiegung der Grundplatte, da somit die Grundplatte nach der Befestigung auf dem Kühlkörper plan auf diesem aufliegt. Bei konkaver Durchbiegung würde keine plane Auflage erfolgen. Bereits bei der Herstellung werden somit die Grundplatten nach dem Stand der Technik mit einer konvexen Durchbiegung gefertigt. Trotz dieser sog. Vorspannung der Grundplatte kann die Lötung der Substrate zu einer konkaven Durchbiegung der Grundplatte führen, falls diese nicht ausreichend steif ausgeführt ist. Eine ausreichende Steifigkeit wird nach dem Stand der Technik durch eine entsprechend dicke Auslegung der Grundplatte erreicht.

Andererseits fordert eine kostengünstige und kompakte Herstellung eines Leistungshalbleitermoduls eine Grundplatte mit möglichst geringer Dicke. Leistungshalbleitermodule, speziell mit im Vergleich zur Querausdehnung wesentlich größerer Längsausdehnung, weisen nach dem Stand der Technik somit entweder den Nachteil einer dicken Grundplatte oder der konkaven Durchbiegung einer dünneren Grundplatte auf.

Der vorliegenden Erfindung liegt daher die Aufgabe zu Grunde ein Herstellungsverfahren für ein Leistungshalbleitermodul vorzustellen, bei dem die Biegesteifigkeit in Längsrichtung der Grundplatte bei gegebener Dicke erhöht ist.

Diese Aufgabe wird gelöst durch ein Verfahren zur Herstellung eines Leistungshalbleitermoduls nach dem Anspruch 1, spezielle Ausgestaltungen finden sich in den Unteransprüchen.

Der Grundgedanke der Erfindung geht aus von einem Leistungshalbleitermodul mit einer Grundplatte zur Montage auf einem Kühlkörper nach dem genannten Stand der Technik bestehend aus einem rahmenartigen Gehäuse mit mindestens einem darin angeordneten elektrisch isolierenden Substrat. Dieses Substrat besteht seinerseits aus einem Isolierstoffkörper mit einer Mehrzahl von auf seiner ersten Hauptfläche befindlichen gegeneinander isolierten metallischen Verbindungsbahnen sowie vorzugsweise aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden ist eine Mehrzahl von Leistungshalbleiterbauelementen angeordnet. Das Leistungshalbleitermodul weist weiterhin nach außen führende Anschlusselemente für Last- und Hilfskontakte auf.

Das erfinderische Verfahren zur Herstellung weist ein Leistungshalbleitermodul mit einer Grundplatte auf, die in Längsrichtung mindestens eine Versteifungsstruktur aufweist. Diese Versteifungsstruktur wird durch Stanzen eines Teiles der Grundplatte gebildet und ragt aus der durch die von der Grundplatte selbst definierten Ebene parallel zum Kühlkörper heraus. Auf dieser Grundplatte ist ein Substrat, vorzugsweise allerdings eine Mehrzahl einzelner Substrate, angeordnet. Vorzugsweise handelt es sich hierbei um eine stoffschlüssige Verbindung, die nach dem Stand der Technik als Lötverbindung ausgebildet ist.

Vorteilhaft an diesem Verfahren zur Herstellung eines Leistungshalbleitermoduls ist, dass bei gegebener Dicke der Grundplatte deren Steifigkeit in Längsrichtung wesentlich erhöht ist und somit eine bei der Herstellung der Grundplatte produzierte konvexe Durchbiegung auch nach der Lötung der Substrate gegeben ist.

Die Erfindung wird anhand von Ausführungsbeispielen in Verbindung mit den Fig. 1 bis 5 näher erläutert.
- Fig. 1: zeigt ein Leistungshalbleitermodul nach dem Stand der Technik in Draufsicht.
- Fig. 2: zeigt einen Schnitt entlang der Linie A-A durch das Leistungshalbleitermodul nach Fig. 1 in Seitenansicht.
- Fig. 3: zeigt einen Schnitt durch ein erfindungsgemäßes hergestelltes Leistungshalbleitermoduls in Seitenansicht.
- Fig. 4: zeigt einen Schnitt durch ein nicht erfindungsgemäß hergestelltes Leistungshalbleitermodul in Seitenansicht.
- Fig. 5: zeigt eine Grundplatte eines erfindungsgemäßen Leistungshalbleitermoduls in dreidimensionaler Ansicht.

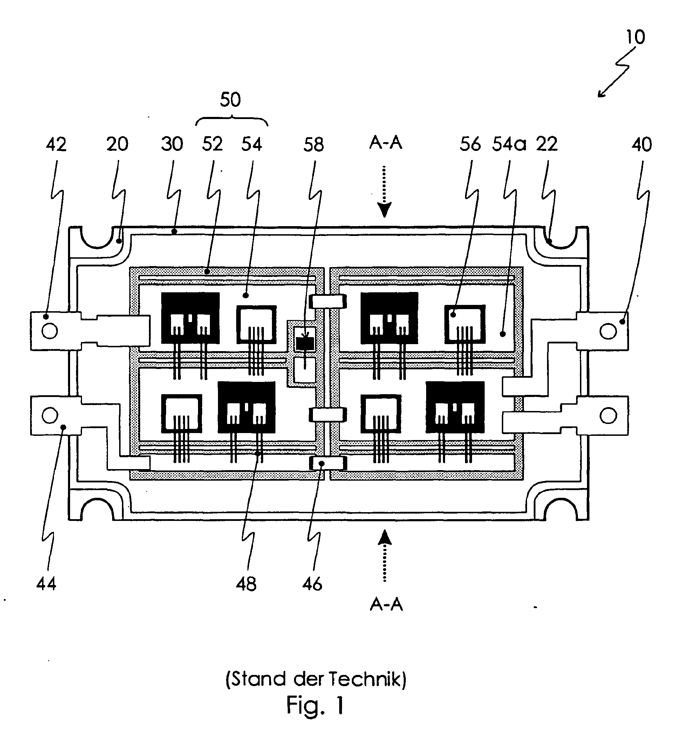

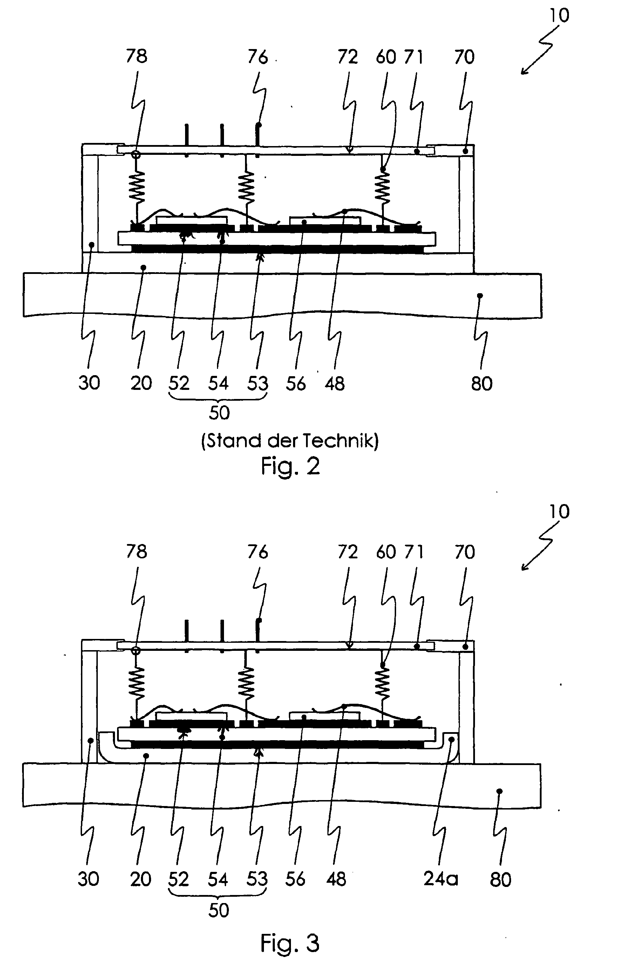

Fig. 1 zeigt ein Leistungshalbleitermodul nach dem Stand der Technik in Draufsicht. Dargestellt ist ein Leistungshalbleitermodul (10) bestehend aus einer Grundplatte (20) zur Montage auf einem Kühlkörper. Hierzu weist diese Grundplatte (20) im Bereich ihrer Ecken jeweils eine Ausnehmung (22) auf. Das Modul besteht weiterhin aus einem rahmenartigen Gehäuse (30) sowie zwei elektrisch isolierenden Substraten (50). Das jeweilige Substrat besteht seinerseits aus einem Isolierstoffkörper (52) mit einer Mehrzahl von auf seiner ersten der Grundplatte abgewandten Hauptfläche befindlichen gegeneinander isolierten metallischen Verbindungsbahnen (54). Auf seiner zweiten der Grundplatte zugewandten Hauptfläche weist das Substrat eine den Verbindungsbahnen der ersten Hauptfläche gleichartige flächige Metallisierung (53, Fig. 2) auf. Auf den Verbindungsbahnen (54) und mit diesen schaltungsgerecht mittels Drahtbondverbindungen (48) verbunden sind Leistungshalbleiterbauelemente (56) sowie ein Sensorikbauteil (58) angeordnet. Zur elektrischen Kontaktierung weist das Teilmodul (10) Anschlusselemente (40, 42, 44) für die Lastanschlüsse auf. Die Verbindungsbahnen (54) der Substrate (50) sind zum Teil miteinander und mit den Anschlusselementen (40) direkt oder mittels Lötbrücken (46) miteinander verbunden.

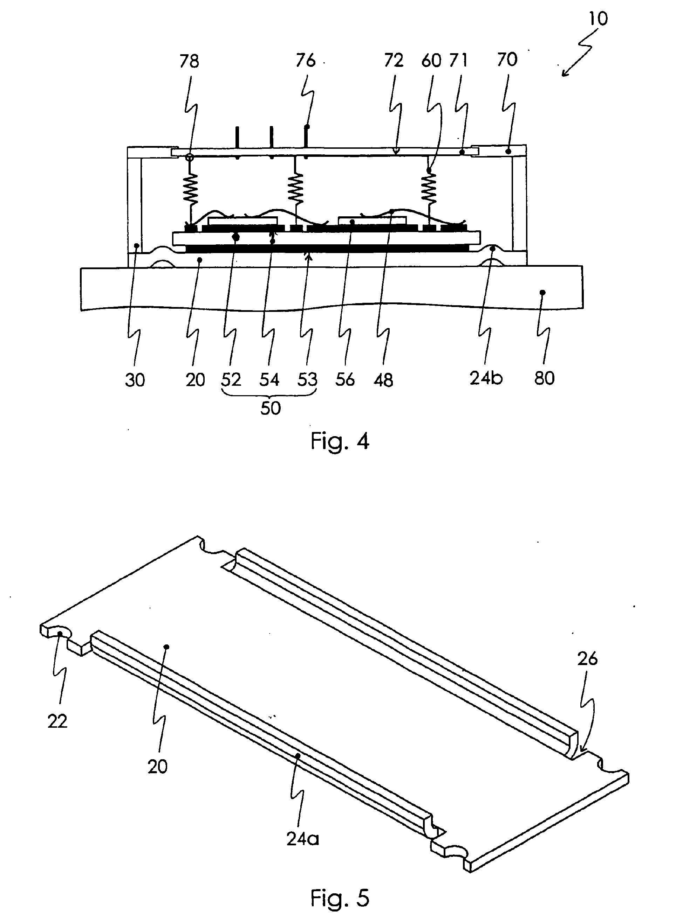

Die Fig. 2 bis 4 zeigen Seitenansichten durch Leistungshalbleitermodule nach dem Stand der Technik (Fig. 2), gemäß der Erfindung (Fig. 3) sowie die Seitenansicht durch ein anderes Leistungs halbleitermodule (Fig. 4) jeweils entlang eines Schnittes A-A (vgl. Fig. 1). Dargestellt ist jeweils ein Leistungshalbleitermodul (10) mit einem rahmenartigen Gehäuse (30) in der Seitenansicht. Auf der Grundplatte (20) angeordnet ist ein sog. DCB- (Direct Copper Bonding) Substrat (50). Dieses besteht aus einem Isolierstoffkörper (52), beispielhaft einer Aluminiumoxid- oder Aluminiumnitridkeramik, mit einer auf seiner der Grundplatte zugewandten Seite flächigen (53) und auf seiner der Grundplatte (20) abgewandten Seite strukturierten Kupferschicht (54). Diese Kupferschicht (54) stellt die Verbindungsbahnen des Leistungshalbleitermoduls dar. Auf diesen Verbindungsbahnen (54) sind die Bauelemente (56), in der Regel Leistungshalbleiterbauelemente und Sensorikbauteile, angeordnet. Die schaltungsgerechten Verbindungen erfolgen mittels Drahtbondverbindungen (48).

Weiterhin sind die Hilfsanschlusselemente des jeweiligen Leistungshalbleitermoduls dargestellt. Diese werden gebildet durch Kontaktfedern (60), auf einer Leiterplatte angeordnete Leiterbahnen (72) sowie Anschlussstifte (76). Die Leiterplatte, auf deren Kontaktflächen (78) diese Kontaktfedern enden, ist hier integraler Bestandteil des Deckels (70). Der Deckel selbst ist hier rahmenartig ausgebildet und umschließt die Leiterplatte an ihren Kanten, ohne sie vollständig zu überdecken.

Fig. 2 zeigt einen Schnitt entlang der Linie A-A durch das Leistungshalbleitermodul nach dem Stand der Technik gemäß Fig. 1 in Seitenansicht. Die Grundplatte (20) besteht aus einer ebene Kupferplatte, die in Längsrichtung eine konvexe Vorspannung von ca. 2mm bei einer Länge von ca. 15cm aufweist.

Fig. 3 zeigt einen Schnitt durch ein erfindungsgemäß hergestelltes Leistungshalbleitermodul in Seitenansicht. Die Längsseiten der Grundplatte (20) sind hier ohne Unterbrechung über einen Abschnitt (24a) zwischen den Ausnehmungen (Fig. 1, 22) jeweils um ca. 90° in Richtung des Modulinneren, also in Richtung der dem Kühlkörper abgewandten Seite der Grundplatte (20), nach oben gebogen. Durch diese Versteifungsstruktur (24) kann eine im Vergleich zum Stand der Technik um mindestens 20% dünnere Grundplatte eingesetzt werden bei gleichzeitiger Erhöhung der Biegesteifigkeit um 60%. Eine konvex vorgespannte Grundplatte behält auch nach der Lötung der Substrate diese konvexe Vorspannung. Die Vorspannung liegt hier ebenfalls wie beim Stand der Technik bei ca. 2mm.

Fig. 4. zeigt einen Schnitt durch ein nicht erfindungsgemäß hergestelltes Leistungshalbleitermodul in Seitenansicht. Hierbei wird eine Versteifungsstruktur (24) der Grundplatte (20) realisiert, indem in mehreren Abschnitten entlang der Längsseite des Leistungshalbleitermoduls (10) in Längsrichtung verlaufende Prägebereiche (24b) angeordnet sind. Diese Prägebereiche sind derart gestaltet, dass auf der dem Kühlkörper (80) zugewandten Seite das Material der Grundlatte (20), in der Regel Kupfer, partiell in Richtung des Modulinneren gedrückt wird. Hierdurch ergibt sich auf der dem Kühlkörper (80) abgewandten Seite der Grundplatte (20) eine Aufwölbung. Hierdurch wird in dem Bereich der Prägung eine Versteifung in Längsrichtung erreicht. Die Prägebereiche (24b) weisen vorteilhafterweise ein Verhältnis Länge zu Breite von mehr als 4:1 auf. Weiterhin ist es vorteilhaft, wenn die einzelnen Prägebereiche sich gegenseitig zu mehr als 20% überlappen. Zusätzlich weist die Grundplatte (20) die oben beschriebene konvexe Vorspannung auf. Alternativ kann selbstverständlich auch eine einzige Prägung (24b) über die gesamte Länge der Grundplatte (20) in Längsrichtung verlaufend angeordnet sein.

Fig. 5 zeigt eine Grundplatte eines erfindungsgemäß hergestellten Leistungshalbleitermoduls in dreidimensionaler Ansicht. Hier ist eine Grundplatte (20, vgl. Fig. 3)) gezeigt, wobei zwischen den für die Schraubverbindung des Leistungshalbleitermoduls (10) mit dem Kühlkörper (80) bestimmten Ausnehmungen (22) an jeder Längsseite durch Einbringen von Aussparungen (26) ein Abschnitt (24a) frei gestanzt. Der Abschnitt (24a) ist aus der durch die Grundplatte selbst gegebenen Ebene heraus in Richtung des Substrates gebogen. Weiterhin ist die Grundplatte (20) konvex, wie oben beschrieben, vorgespannt. Die Ausgestaltung der Grundplatte (20) des erfindungsgemäßen hergestellten Leistungshalbleiterbauelements erfolgt in bekannter Stanz- Biege- Technik.

## Patentansprüche

1. Verfahren zur Herstellung eines Leistungshalbleitermoduls (10),
wobei das Leistungshalbleitermodul (10) besteht aus einer metallischen Grundplatte (20) zur Montage auf einem Kühlkörper (80), einem rahmenartigen Gehäuse (30), einem Deckel (70), nach außen führenden Anschlusselementen für Last- (40, 42, 44) und Hilfskontakte (76) und mindestens einem innerhalb des Gehäuses (30) angeordneten elektrisch isolierenden Substrat (50), das seinerseits besteht aus einem Isolierstoffkörper (52) und einer auf dessen der Grundplatte (20) abgewandten ersten Hauptfläche befindlichen Mehrzahl von gegeneinander elektrisch isolierten metallischen Verbindungsbahnen (54), darauf befindlichen und mit diesen Verbindungsbahnen schaltungsgerecht verbundenen Leistungshalbleiterbauelementen (56) sowie mindestens einer auf dessen der Grundplatte (20) zugewandten zweiten Hauptfläche befindlichen metallischen Schicht (53), wobei das Substrat (50) auf der Grundplatte (20) angeordnet ist und wobei die Grundplatte (20) eine Versteifungsstruktur (24) aufweist, die in Längsrichtung der Grundplatte (20) verläuft,
wobei diese Versteifungsstruktur (24) aus dem Grundplattenmaterial selbst gebildet ist und aus der durch die Grundplatte gegebenen Ebene herausragt, wobei die Versteifungsstruktur (24) aus Abschnitten (24a) der Längsseiten der Grundplatte (20) hergestellt wird, die aus der durch die Grundplatte selbst gegebenen Ebene heraus in Richtung des Substrates (50) gebogen werden,
wobei die Grundplatte (20) als Stanz- Biege- Teil hergestellt wird, und wobei die Abschnitte (24a) zur Versteifung durch Einbringen von Aussparungen (26) frei gestanzt werden.

2. Verfahren zur Herstellung eines Leistungshalbleitermoduls (10) nach Anspruch 1, wobei die Grundplatte (20) eine Mehrzahl von Ausnehmungen (22) zur Schraubverbindung des Leistungshalbleitermoduls mit dem Kühlkörper (80) aufweist.

3. Verfahren zur Herstellung eines Leistungshalbleitermoduls (10) nach Anspruch 1, wobei die Grundplatte (20) mit der metallischen Schicht (53) des Substrats (50) mittels einer flächig ausgeführten Lötung stoffbündig verbundene wird.

4. Verfahren zur Herstellung eines Leistungshalbleitermoduls (10) nach Anspruch 1, wobei die Abschnitte (24a) jeder Seite unterbrochen angeordnet sind.

5. Verfahren zur Herstellung eines Leistungshalbleitermoduls (10) nach Anspruch 1, wobei der jeweilige Abschnitt (24a) zur Versteifung zwischen Ausnehmungen (22) der Grundplatte (20) für Schraubverbindungen angeordnet und von diesen beabstandet ist.

6. Verfahren zur Herstellung eines Leistungshalbleitermoduls (10) nach Anspruch 1, wobei die Abschnitte (24a) im rechten Winkel zur Grundplatte (20) in dem Kühlkörper (80) abgewandter Richtung gebogen werden.

## Claims

1. Method for producing a power semiconductor module (10), wherein the power semiconductor module (10) consists of a metallic baseplate (20) for mounting on a heat sink (80), a frame-like housing (30), a lid (70), outwardly leading terminal elements for load (40, 42, 44) and auxiliary contacts (76) and at least one electrically insulating substrate (50) which is arranged inside the housing (30), which substrate for its part consists of an insulant body (52) and a plurality of metallic connecting tracks (54) which are electrically insulated from each other and are situated on the first main side, which faces away from the baseplate (20), of the substrate, of power semiconductor components (56) which are situated on the said connecting tracks and connected to these connecting tracks for the circuit, and of at least one metallic layer (53) which is situated on the second main face, which faces the baseplate (20), of the substrate, wherein the substrate (50) is arranged on the baseplate (20) and wherein the baseplate (20) has a reinforcing structure (24) which runs in the longitudinal direction of the baseplate (20),
wherein this reinforcing structure (24) is formed from the baseplate material itself and projects out of the plane defined by the baseplate,
wherein the reinforcing structure (24) is produced from sections (24a) of the longitudinal sides of the baseplate (20), which are bent out of the plane defined by the baseplate itself in the direction of the substrate (50),
wherein the baseplate (20) is produced as a punched and bent part and wherein the sections (24a) for reinforcing are freely punched by introducing cut-outs (26).

2. Method for producing a power semiconductor module (10) according to Claim 1, wherein the baseplate (20) has a plurality of recesses (22) for screw-connecting the power semiconductor module to the heat sink (80).

3. Method for producing a power semiconductor module (10) according to Claim 1, wherein the baseplate (20) is connected in a materially bonded manner to the metallic layer (53) of the substrate (50) by means of a flat solder.

4. Method for producing a power semiconductor module (10) according to Claim 1, wherein the section (24a) of each side are arranged in an interrupted manner.

5. Method for producing a power semiconductor module (10) according to Claim 1, wherein the respective section (24a) for reinforcing is arranged between recesses (22) of the baseplate (20) for screw-connections and at a distance from these recesses.

6. Method for producing a power semiconductor module (10) according to Claim 1, wherein the sections (24a) are bent at a right angle to the baseplate (20) in the direction facing away from the heat sink (80).

## Revendications

1. Procédé pour fabriquer un module à semi-conducteurs de puissance (10), le module à semi-conducteurs de puissance (10) se composant d'une plaque de base (20) métallique pour le montage sur un corps réfrigérant (80), d'un boîtier (30) de type cadre, d'un couvercle (70), d'éléments de raccordement allant vers l'extérieur pour des contacts de charge (40, 42, 44) et des contacts auxiliaires (76) et d'au moins un substrat (50) électro-isolant disposé à l'intérieur du boîtier (30), lequel substrat se compose pour sa part d'un corps en matériau isolant (52) et d'une pluralité de bandes de liaison (54) métalliques isolées électriquement les unes par rapport aux autres, se trouvant sur la première surface principale du corps, opposée à la plaque de base (20), de composants à semi-conducteurs de puissance (56) se trouvant dessus et reliés par circuit adapté à ces bandes de liaison et d'au moins une couche (53) métallique se trouvant sur la seconde surface principale du corps, tournée vers la plaque de base (20), le substrat (50) étant disposé sur la plaque de base (20) et la plaque de base (20) présentant une structure de renfort (24) qui est agencée dans le sens longitudinal de la plaque de base (20),
cette structure de renfort (24) étant formée à base du matériau de la plaque de base même et dépassant du plan formé par la plaque de base, la structure de renfort (24) étant fabriquée à base de parties (24a) des côtés longitudinaux de la plaque de base (20), qui sont pliées à partir du plan généré par la plaque de base même en direction du substrat (50),
la plaque de base (20) étant fabriquée comme partie découpée et pliée et les parties (24a) pour le renfort étant découpées librement par l'introduction d'évidements (26).

2. Procédé pour fabriquer un module à semi-conducteurs de puissance (10) selon la revendication 1, la plaque de base (20) présentant une pluralité d'évidements (22) pour l'assemblage vissé du module à semi-conducteurs avec le corps réfrigérant (80).

3. Procédé pour fabriquer un module à semi-conducteurs de puissance (10) selon la revendication 1, la plaque de base (20) étant reliée par adhésion par matière à la couche (53) métallique du substrat (50) au moyen d'un brasage réalisé à plat.

4. Procédé pour fabriquer un module à semi-conducteurs de puissance (10) selon la revendication 1, les parties (24a) de chaque côté étant disposées de façon discontinue.

5. Procédé pour fabriquer un module à semi-conducteurs de puissance (10) selon la revendication 1, la partie (24a) respective pour le renfort étant disposée entre des évidements (22) de la plaque de base (20) pour des assemblages vissés et étant espacée de ceux-ci.

6. Procédé pour fabriquer un module à semi-conducteurs de puissance (10) selon la revendication 1, les parties (24a) étant pliées à angle droit par rapport à la plaque de base (20) dans la direction opposée au corps réfrigérant (80).
